(19) Europäisches Patentamt
European Patent Office
Office européen des brevets

(11) EP 3 467 040 A1

(12) EUROPEAN PATENT APPLICATION
published in accordance with Art. 153(4) EPC

(43) Date of publication:
**10.04.2019 Bulletin 2019/15**

(21) Application number: **17802772.8**

(22) Date of filing: **23.05.2017**

(51) Int Cl.:
***C08L 79/08*** (2006.01) ***C08G 73/10*** (2006.01)
***C08K 5/3415*** (2006.01) ***C09D 7/12*** (2006.01)
***C09D 179/08*** (2006.01)

(86) International application number:
**PCT/JP2017/019117**

(87) International publication number:
**WO 2017/204186 (30.11.2017 Gazette 2017/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **23.05.2016 JP 2016102471**

(71) Applicant: **Nissan Chemical Corporation**
**Tokyo 103-6119 (JP)**

(72) Inventors:
- **EBARA Kazuya**
**Funabashi-shi**
**Chiba 274-0052 (JP)**
- **SHINDO Kazuya**
**Funabashi-shi**
**Chiba 274-0052 (JP)**

(74) Representative: **Mewburn Ellis LLP**
**City Tower**
**40 Basinghall Street**
**London EC2V 5DE (GB)**

# (54) DETACHABLE LAYER-FORMING COMPOSITION AND DETACHABLE LAYER

(57) Provided is a detachable layer-forming composition which, for example, contains an organic solvent and a polyamic acid, both ends of which are derived from a diamine and sealed with an aromatic dicarboxylic acid, such as the polyamic acid represented by this formula.

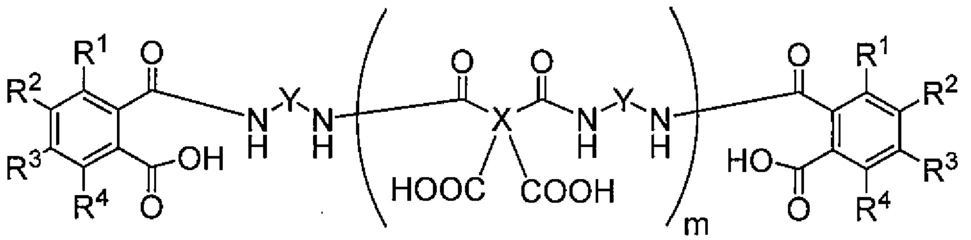

(1)

(In the formula, X represents a tetravalent aromatic group, Y represents a divalent aromatic group, $R^1$-$R^4$ each independently represent a hydrogen atom, a C1-10 alkyl group, or a C6-20 aryl group, and m is a natural number.)

EP 3 467 040 A1

## Description

### TECHNICAL FIELD

The present invention relates to a release layer-forming composition and a release layer.

### BACKGROUND ART

In recent years, it has been desired that electronic devices, in addition to being imparted with reduced thinness and lighter weight, also be given an ability to bend. This has led to a need for the use of flexible, lightweight plastic substrates in place of conventional glass substrates, which are heavy, brittle and incapable of bending.

In connection with new-generation displays in particular, there exists a desire for the development of active matrix full-color TFT display panels which use flexible, lightweight plastic substrates (referred to below as "plastic substrates").

Hence, methods for manufacturing electronic devices in which a plastic film is used as a substrate are starting to be variously investigated, and studies are being carried out on processes that allow equipment for the fabrication of existing TFT display panels to be converted for use on new-generation displays. Patent Documents 1, 2 and 3 disclose methods which form an amorphous silicon thin-film layer on top of a glass substrate, form a plastic substrate on top of the thin-film layer, and subsequently irradiate the assembly with a laser from the glass substrate side, causing the amorphous silicon to crystallize and, by way of the hydrogen gas that evolves with such crystallization, separating the plastic substrate from the glass substrate.

Patent Document 4 discloses a method for completing the production of a liquid-crystal display by, using the art disclosed in Patent Documents 1 to 3, attaching to a plastic film a layer to be released (referred to in Patent Document 4 as "a layer to be transferred").

However, the methods disclosed in Patent Documents 1 to 4, particularly that disclosed in Patent Document 4, have a number of drawbacks: a substrate having a high translucency must be used in order to allow laser light to pass through, the irradiation of laser light of relatively high energy which is sufficient to pass through the substrate and also to cause the release of hydrogen included in the amorphous silicon is required, and the layer to be released may incur damage from such laser light irradiation.

Moreover, in cases where the layer to be released has a large surface area, laser treatment takes a long time, making it difficult to increase the productivity of device fabrication.

Patent Document 5 employs, as a means for resolving such problems, a production process in which, using an existing glass substrate as the base (referred to below as the "glass base"), a polymer such as a cyclic olefin copolymer is used to form a release layer on top of the glass base, a heat-resistant plastic film such as a polyimide film is formed on top of the release film, and an indium-tin oxide (ITO) transparent electrode, thin-film transistor (TFT) or the like is formed and sealed by a vacuum process on top of the film, following which, last of all, the glass base is released and removed.

Low-temperature polysilicon TFTs, which have a mobility that is twice as fast as that of amorphous silicon TFTs, are currently used as TFTs. In the production of such low-temperature polysilicon TFTs, following the vapor deposition of amorphous silicon, it is necessary to crystallize the silicon by carrying out dehydrogenation annealing at 400°C or above and irradiating with a pulsed laser (these operations are referred to below as the "TFT process"). Yet, the temperature of the dehydrogenation annealing step is at or above the glass transition temperature (Tg) of existing polymers.

Adhesiveness is known to rise when existing polymers are heated to a temperature at or above the Tg (see, for example, Patent Document 6). As a result, adhesion between the release layer and a plastic substrate rises following heat treatment, which has made release of the plastic substrate from the base difficult.

### PRIOR ART DOCUMENTS

### PATENT DOCUMENTS

Patent Document 1: JP-A H10-125929
Patent Document 2: JP-A H10-125931
Patent Document 3: WO 2005/050754
Patent Document 4: JP-A H10-125930
Patent Document 5: JP-A 2010-111853
Patent Document 6: JP-A 2008-188792

SUMMARY OF INVENTION

TECHNICAL PROBLEM

Accordingly, the object of this invention is to provide a release layer-forming composition that gives a release layer which enables the plastic substrate of a flexible electronic device formed thereon to be released without incurring damage, and which has a releasability that does not change even after heat treatment at a relatively high temperature in the subsequently described TFT process and the like.

SOLUTION TO PROBLEM

The inventors have conducted extensive investigations in order to resolve the above problems. As a result, they have discovered that a composition which includes a polyamic acid in which both ends of the molecular chain are derived from a diamine and capped with an aromatic dicarboxylic acid and includes also an organic solvent gives a release layer which adheres firmly to a base such as a glass substrate and has a suitable adhesion to and a suitable releasability from plastic substrates used in flexible electronic devices, and that the suitable adhesion and suitable releasability of the release layer are retained well without changing even after heat treatment in the TFT process.

Accordingly, the invention provides the following release layer-forming composition and release layer.

[1] A release layer-forming composition which includes a polyamic acid, both ends of which are derived from a diamine and capped with an aromatic dicarboxylic acid, and an organic solvent.

[2] The release layer-forming composition of [1], wherein the aromatic dicarboxylic acid has an aromatic ring of from 6 to 30 carbon atoms.

[3] The release layer-forming composition of [2], wherein the polyamic acid is represented by formula (1) below.

[Chem. 1]

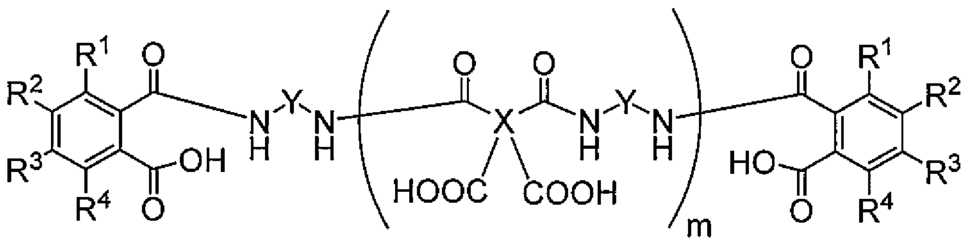

(1)

(wherein X is a tetravalent aromatic group, Y is a divalent aromatic group, $R^1$ to $R^4$ are each independently a hydrogen atom, an alkyl group of 1 to 10 carbon atoms or an aryl group of 6 to 20 carbon atoms, and m is a natural number).

[4] The release layer-forming composition of [3], wherein $R^1$ to $R^4$ are hydrogen atoms.

[5] The release layer-forming composition of [3] or [4], wherein Y is a divalent aromatic group that includes from 1 to 5 benzene rings.

[6] The release layer-forming composition of [5], wherein Y is at least one group selected from those of formulas (2) to (4) below.

[Chem. 2]

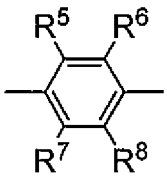
(2)

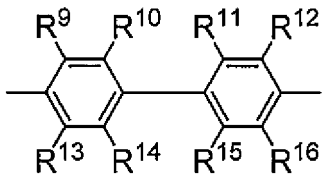
(3)

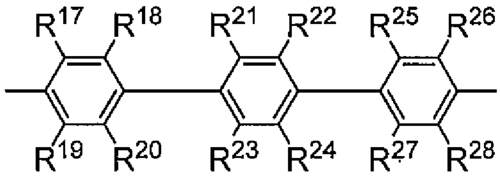
(4)

(wherein $R^5$ to $R^{28}$ are each independently a hydrogen atom, a halogen atom, a hydroxyl group, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom).

[7] The release layer-forming composition of [6], wherein $R^5$ to $R^{28}$ are hydrogen atoms.

[8] The release layer-forming composition of any of [3] to [7], wherein X is a tetravalent aromatic group that includes from 1 to 5 benzene rings.

[9] The release layer-forming composition of any of [3] to [8], wherein X is a phenyl group or a biphenyl group.

[10] The release layer-forming composition of any of [3] to [9], wherein m is a natural number of up to 100.

[11] The release layer-forming composition of any of [1] to [10], wherein the organic solvent is at least one selected from the group consisting of amides of formula (S1), amides of formula (S2) and amides of formula (S3).

[Chem. 3]

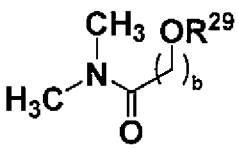
(S1)

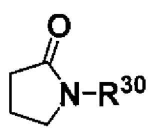
(S2)

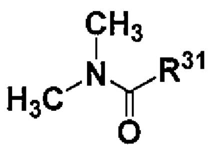
(S3)

(wherein $R^{29}$ and $R^{30}$ are each independently an alkyl group of 1 to 10 carbon atoms, $R^{31}$ is a hydrogen atom or an alkyl group of 1 to 10 carbon atoms, and b is a natural number).

[12] A release layer formed with the release layer-forming composition of any of [1] to [11].

[13] A method of manufacturing a flexible electronic device having a plastic substrate, which method comprises using the release layer of [12].

[14] The manufacturing method of [13], wherein the plastic substrate is a substrate made of polyimide.

## ADVANTAGEOUS EFFECTS OF INVENTION

By using the release layer-forming composition of the invention, a release layer which firmly adheres to a base and has a suitable adhesion to and a suitable releasability from a plastic substrate can be reproducibly obtained. Therefore, it is possible, in a flexible electronic device manufacturing process, for a plastic substrate that has been formed on a base to be separated, together with a circuit or the like provided thereon, from the base without damaging the plastic substrate or the circuit. The release layer-forming composition of the invention is thus able to contribute to greater simplification and improved yield in processes for manufacturing flexible electronic devices having plastic substrates.

## DESCRIPTION OF EMBODIMENTS

The invention is described more fully below.

The release layer-forming composition of the invention includes a polyamic acid in which both ends of the molecular chain are derived from a diamine and capped with an aromatic dicarboxylic acid (referred to below as a "carboxylic acid-capped polyamic acid"), and an organic solvent.

In this invention, "release layer" refers to a layer provided directly on a base (such as a glass base) on which a plastic substrate is to be formed. A typical example is, in a flexible electronic device manufacturing process, a release layer which is provided between the base and a plastic substrate made of a resin such as polyimide in a flexible electronic device for the purpose of anchoring the plastic substrate in a given process, and which is designed so that, following the formation of an electronic circuit or the like on the plastic substrate, the plastic substrate can be easily released from the base.

The carboxylic acid-capped polyamic acid can be obtained by reacting a tetracarboxylic dianhydride component with a diamine component to form a polyamic acid having amino groups at both ends of the molecular chain, and additionally reacting the polyamic acid with an aromatic dicarboxylic acid or an aromatic dicarboxylic acid anhydride.

The tetracarboxylic dianhydride component and the diamine component may be acyclic, alicyclic, aromatic or aralicyclic. However, in this invention, from the standpoint of increasing the function of the resulting film as a release layer, a polyamic acid obtained by reacting an aromatic tetracarboxylic dianhydride-containing acid dianhydride component with an aromatic diamine-containing diamine component is preferred, and a wholly aromatic polyamic acid obtained by reacting an aromatic tetracarboxylic dianhydride with an aromatic diamine is more preferred.

Although the aromatic dicarboxylic acid or aromatic dicarboxylic acid anhydride is not particularly limited, as subsequently described, an aromatic dicarboxylic acid having an aromatic ring of 6 to 30 carbon atoms is preferred.

The carboxylic acid-capped polyamic acid is preferably a compound having the structure represented by formula (1) below.

[Chem. 4]

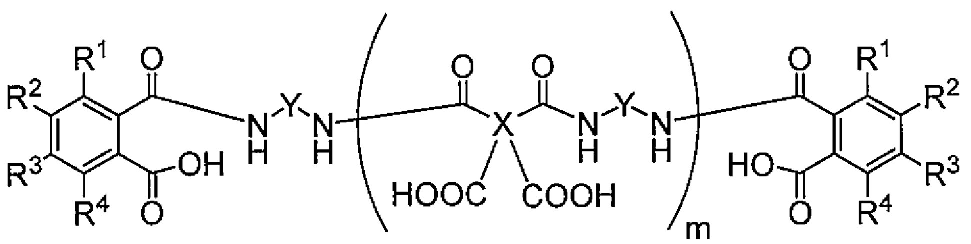

(1)

In formula (1), X is a tetravalent aromatic group, Y is a divalent aromatic group, $R^1$ to $R^4$ are each independently a hydrogen atom, an alkyl group of 1 to 10 carbon atoms or an aryl group of 6 to 20 carbon atoms, and the subscript m is a natural number.

The alkyl group of 1 to 10 carbon atoms in $R^1$ to $R^4$ may be linear, branched or cyclic. Examples include methyl, ethyl, n-propyl, isopropyl, cyclopropyl, n-butyl, isobutyl, s-butyl, t-butyl, n-pentyl, 1-methyl-n-butyl, 2-methyl-n-butyl, 3-methyl-n-butyl, 1,1-dimethyl-n-propyl, 1,2-dimethyl-n-propyl, 2,2-dimethyl-n-propyl, 1-ethyl-n-propyl, cyclopentyl, n-hexyl, 1-methyl-n-pentyl, 2-methyl-n-pentyl, 3-methyl-n-pentyl, 4-methyl-n-pentyl, 1,1-dimethyl-n-butyl, 1,2-dimethyl-n-butyl, 1,3-dimethyl-n-butyl, 2,2-dimethyl-n-butyl, 2,3-dimethyl-n-butyl, 3,3-dimethyl-n-butyl, 1-ethyl-n-butyl, 2-ethyl-n-butyl, 1,1,2-trimethyl-n-propyl, 1,2,2-trimethyl-n-propyl, 1-ethyl-1-methyl-n-propyl, 1-ethyl-2-methyl-n-propyl, cyclohexyl, n-heptyl, n-octyl, n-nonyl and n-decyl groups.

Examples of the aryl group of 6 to 20 carbon atoms include phenyl, 1-naphthyl, 2-naphthyl, 1-anthryl, 2-anthryl, 9-anthryl, 1-phenanthryl, 2-phenanthryl, 3-phenanthryl, 4-phenanthryl and 9-phenanthryl groups.

Of these, $R^1$ to $R^4$ are preferably hydrogen atoms, alkyl groups of 1 to 5 carbon atoms or aryl groups of 6 to 10 carbon atoms; more preferably hydrogen atoms or alkyl groups of 1 to 5 carbon atoms; and most preferably all hydrogen atoms.

X is preferably an aromatic group containing from 1 to 5 benzene rings, more preferably a phenyl, naphthyl or biphenyl group, and even more preferably a phenyl or biphenyl group.

Y is preferably an aromatic group containing from 1 to 5 benzene rings, and more preferably an aromatic group of at least one type selected from those of formulas (2) to (4) below.

[Chem. 5]

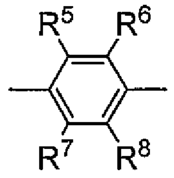

(2)

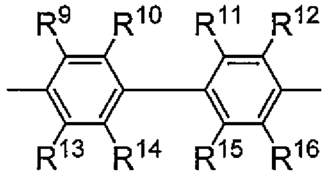

(3)

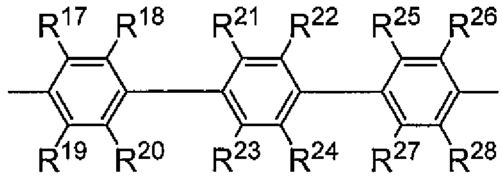

(4)

In formulas (2) to (4), $R^5$ to $R^{28}$ are each independently a hydrogen atom, a hydroxyl group, a halogen atom, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom.

Examples of the halogen atom include fluorine, chlorine, bromine and iodine atoms.

The alkyl group of 1 to 20 carbon atoms may be linear, branched or cyclic. Specific examples include, in addition to the groups mentioned above as exemplary alkyl groups of 1 to 10 carbon atoms: n-undecyl, n-dodecyl, n-tridecyl, n-tetradecyl, n-pentadecyl, n-hexadecyl, n-heptadecyl, n-octadecyl, n-nonadecyl and n-eicosanyl groups.

Examples of alkenyl groups of 2 to 20 carbon atoms include ethenyl, n-1-propenyl, n-2-propenyl, 1-methylethenyl, n-1-butenyl, n-2-butenyl, n-3-butenyl, 2-methyl-1-propenyl, 2-methyl-2-propenyl, 1-ethylethenyl, 1-methyl-1-propenyl, 1-methyl-2-propenyl, n-1-pentenyl, n-1-decenyl and n-1-eicosenyl groups.

Specific examples of alkynyl groups of 2 to 20 carbon atoms include ethynyl, n-1-propynyl, n-2-propynyl, n-1-butynyl, n-2-butynyl, n-3-butynyl, 1-methyl-2-propynyl, n-1-pentynyl, n-2-pentynyl, n-3-pentynyl, n-4-pentynyl, 1-methyl-n-butynyl, 2-methyl-n-butynyl, 3-methyl-n-butynyl, 1,1-dimethyl-n-propynyl, n-1-hexynyl, n-1-decynyl, n-1-pentadecynyl and n-1-eicosynyl groups.

Specific examples of heteroaryl groups of 2 to 20 carbon atoms include oxygen-containing heteroaryl groups such as 2-thienyl, 3-thienyl, 2-furanyl, 3-furanyl, 2-oxazolyl, 4-oxazolyl, 5-oxazolyl, 3-isooxazolyl, 4-isooxazolyl and 5-isooxazolyl groups; sulfur-containing heteroaryl groups such as 2-thiazolyl, 4-thiazolyl, 5-thiazolyl, 3-isothiazolyl, 4-isothiazolyl and 5-isothiazolyl groups; and nitrogen-containing heteroaryl groups such as 2-imidazolyl, 4-imidazolyl, 2-pyridyl, 3-pyridyl, 4-pyridyl, 2-pyrazyl, 3-pyrazyl, 5-pyrazyl, 6-pyrazyl, 2-pyrimidyl, 4-pyrimidyl, 5-pyrimidyl, 6-pyrimidyl, 3-pyridazyl, 4-pyridazyl, 5-pyridazyl, 6-pyridazyl, 1,2,3-triazin-4-yl, 1,2,3-triazin-5-yl, 1,2,4-triazin-3-yl, 1,2,4-triazin-5-yl, 1,2,4-triazin-6-yl, 1,3,5-triazin-2-yl, 1,2,4,5-tetrazin-3-yl, 1,2,3,4-tetrazin-5-yl, 2-quinolinyl, 3-quinolinyl, 4-quinolinyl, 5-quinolinyl, 6-quinolinyl, 7-quinolinyl, 8-quinolinyl, 1-isoquinolinyl, 3-isoquinolinyl, 4-isoquinolinyl, 5-isoquinolinyl, 6-isoquinolinyl, 7-isoquinolinyl, 8-isoquinolinyl, 2-quinoxanyl, 5-quinoxanyl, 6-quinoxanyl, 2-quinazolinyl, 4-quinazolinyl, 5-quinazolinyl, 6-quinazolinyl, 7-quinazolinyl, 8-quinazolinyl, 3-cinnolinyl, 4-cinnolinyl, 5-cinnolinyl, 6-cinnolinyl, 7-cinnolinyl and 8-cinnolinyl groups.

Specific examples of aryl groups of 6 to 20 carbon atoms include the same as those mentioned above.

Of these, $R^5$ to $R^{28}$ are preferably hydrogen atoms, fluorine atoms, cyano groups, alkyl groups of 1 to 20 carbon atoms which may be substituted with halogen atoms, aryl groups of 6 to 20 carbon atoms which may be substituted with halogen atoms, or heteroaryl groups of 2 to 20 carbon atoms which may be substituted with halogen atoms; more preferably hydrogen atoms, fluorine atoms, cyano groups, alkyl groups of 1 to 10 carbon atoms which may be substituted with halogen atoms, or phenyl groups which may be substituted with halogen atoms; even more preferably hydrogen

atoms, fluorine atoms, methyl groups or trifluoromethyl groups; and most preferably hydrogen atoms.

The subscript m is a natural number, preferably a natural number up to 100, and more preferably a natural number from 2 to 100.

Tetracarboxylic dianhydride components, diamine components, and aromatic dicarboxylic acids or aromatic dicarboxylic acid anhydrides that may be used to synthesize the carboxylic acid-capped polyamic acid having the structure represented in formula (1) are described in detail below.

The aromatic tetracarboxylic dianhydride is not particularly limited, provided it has two dicarboxylic anhydride sites on the molecule and also has an aromatic ring. However, as mentioned above, an aromatic tetracarboxylic dianhydride containing from 1 to 5 benzene rings is preferred.

Specific examples include pyromellitic dianhydride, benzene-1,2,3,4-tetracarboxylic dianhydride, naphthalene-1,2,3,4-tetracarboxylic dianhydride, naphthalene-1,2,5,6-tetracarboxylic dianhydride, naphthalene-1,2,6,7-tetracarboxylic dianhydride, naphthalene-1,2,7,8-tetracarboxylic dianhydride, naphthalene-2,3,5,6-tetracarboxylic dianhydride, naphthalene-2,3,6,7-tetracarboxylic dianhydride, naphthalene-1,4,5,8-tetracarboxylic dianhydride, biphenyl-2,2'-3,3'-tetracarboxylic dianhydride, bipheny1-2,3,3',4'-tetracarboxylic dianhydride, biphenyl-3,3 ',4,4'-tetracarboxylic dianhydride, anthracene-1,2,3,4-tetracarboxylic dianhydride, anthracene-1,2,5,6-tetracarboxylic dianhydride, anthracene-1,2,6,7-tetracarboxylic dianhydride, anthracene-1,2,7,8-tetracarboxylic dianhydride, anthracene-2,3,6,7-tetracarboxylic dianhydride, phenanthrene-1,2,3,4-tetracarboxylic dianhydride, phenanthrene-1,2,5,6-tetracarboxylic dianhydride, phenanthrene-1,2,6,7-tetracarboxylic dianhydride, phenanthrene-1,2,7,8-tetracarboxylic dianhydride, phenanthrene-1,2,9,10-tetracarboxylic dianhydride, phenanthrene-2,3,5,6-tetracarboxylic dianhydride, phenanthrene-2,3,6,7-tetracarboxylic dianhydride, phenanthrene-2,3,9,10-tetracarboxylic dianhydride, phenanthrene-3,4,5,6-tetracarboxylic dianhydride and phenanthrene-3,4,9,10-tetracarboxylic dianhydride.

These may be used singly, or two or more may be used in combination.

Of these, from the standpoint of increasing the function of the resulting film as a release layer, an aromatic carboxylic dianhydride having one or two benzene rings is preferred. Specifically, one or more aromatic tetracarboxylic dianhydride of any of formulas (C1) to (C12) is preferred, and one or more aromatic tetracarboxylic dianhydride of any of formulas (C1) to (C7) and (C9) to (C11) is more preferred.

[Chem. 6]

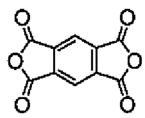
(C1)

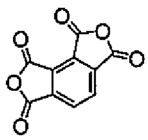
(C2)

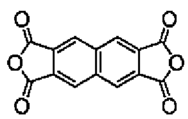
(C3)

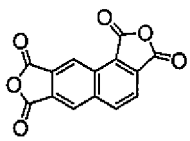
(C4)

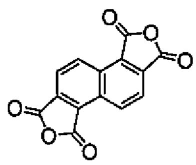
(C5)

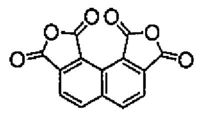
(C6)

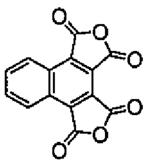
(C7)

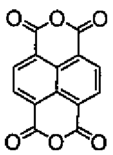
(C8)

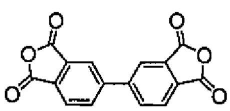
(C9)

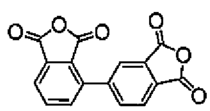
(C10)

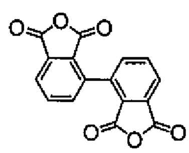
(C11)

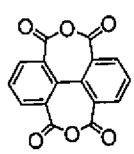
(C12)

Another tetracarboxylic dianhydride may be used together with the above aromatic tetracarboxylic dianhydride, provided that doing so does not have an adverse effect on the resulting release layer.

Specific examples of such other tetracarboxylic dianhydrides include alicyclic tetracarboxylic dianhydrides such as 1,2,3,4-cyclobutanetetracarboxylic dianhydride, 2,3,4,5-tetrahydrofurantetracarboxylic dianhydride, 1,2,4,5-cyclohexanoic dianhydride, 3,4-dicarboxy-1-cyclohexylsuccinic dianhydride, 3,4-dicarboxy-1,2,3,4-tetrahydro-1-naphthalenesuccinic dianhydride and bicyclo[3.3.0]octane-2,4,6,8-tetracarboxylic dianhydride.

The amount of aromatic tetracarboxylic dianhydride used in this invention is preferably at least 70 mol%, more preferably at least 80 mol%, even more preferably at least 90 mol%, still more preferably at least 95 mol%, and most preferably 100 mol%, of the overall tetracarboxylic dianhydride.

By using such an amount, a film which firmly adheres to the base and has a suitable adhesion to and a suitable releasability from the plastic substrate can be reproducibly obtained.

The aromatic diamine is not particularly limited, provided that it has two amino groups which bond directly to

an aromatic ring within the molecule. Aromatic diamines which include from 1 to 5 benzene rings are preferred.

Specific examples of aromatic diamines having the above structure include diamines having one benzene ring, such as 1,4-diaminobenzene (p-phenylenediamine), 1,3-diaminobenzene (m-phenylenediamine), 1,2-diaminobenzene (o-phenylenediamine), 2,4-diaminotoluene, 2,5-diaminotoluene, 2,6-diaminotoluene, 4,6-dimethyl-m-phenylenediamine, 2,5-dimethyl-p-phenylenediamine, 2,6-dimethyl-p-phenylenediamine, 2,4,6-trimethyl-1,3-phenylenediamine, 2,3,5,6-tetramethyl-p-phenylenediamine, m-xylylenediamine, p-xylylenediamine, 5-trifluoromethylbenzene-1,3-diamine, 5-trifluoromethylbenzene-1,2-diamine and 3,5-bis(trifluoromethyl)benzene-1,2-diamine; diamines having two benzene rings, such as 1,2-naphthalenediamine, 1,3-naphthalenediamine, 1,4-naphthalenediamine, 1,5-naphthalenediamine, 1,6-naphthalenediamine, 1,7-naphthalenediamine, 1,8-naphthalenediamine, 2,3-naphthalenediamine, 2,6-naphthalenediamine, 4,4'-biphenyldiamine, 2,2'-bis(trifluoromethyl)-4,4'-diaminobiphenyl, 3,3 '-dimethyl-4,4'-diaminodiphenylmethane, 3,3 '-dicarboxy-4,4'-diaminodiphenylmethane, 3,3',5,5'-tetramethyl-4,4'-diaminodiphenylmethane, 4,4'-diaminobenzanilide, 3,3'-dichlorobenzidine, 3,3'-dimethylbenzidine, 2,2'-dimethylbenzidine, 3,3'-diaminodiphenylmethane, 3,4'-diaminodiphenylmethane, 4,4'-diaminodiphenylmethane, 2,2-bis(3-aminophenyl)propane, 2,2-bis(4-aminophenyl)propane, 2,2-bis(3-aminophenyl)-1,1,1,3,3,3-hexafluoropropane, 2,2-bis(4-aminophenyl)-1,1,1,3,3,3-hexafluoropropane, 3,3'-diaminodiphenylsulfoxide, 3,4'-diaminodiphenylsulfoxide, 4,4' -diaminodiphenylsulfoxide, 3,3'-bis(trifluoromethyl)biphenyl-4,4'-diamine, 3,3',5,5'-tetrafluorobiphenyl-4,4'-diamine, 4,4'-diaminooctafluorobiphenyl, 2-(3-aminophenyl)-5-aminobenzimidazole and 2-(4-aminophenyl)-5-aminobenzoxazole; and diamines having three benzene rings, such as 1,5-diaminoanthracene, 2,6-diaminoanthracene, 9,10-diaminoanthracene, 1,8-diaminophenanthrene, 2,7-diaminophenanthrene, 3,6-diaminophenanthrene, 9,10-diaminophenanthrene, 1,3-bis(3-aminophenyl)benzene, 1,3 -bis(4-aminophenyl)benzene, 1,4-bis(3-aminophenyl)benzene, 1 ,4-bis(4-aminophenyl)benzene, 1,3-bis(3-aminophenylsulfide)benzene, 1,3-bis(4-aminophenylsulfide)benzene, 1,4-bis(4-aminophenylsulfide)benzene, 1,3-bis(3-aminophenylsulfone)benzene, 1,3-bis(4-aminophenylsulfone)benzene, 1,4-bis(4-aminophenylsulfone)benzene, 1,3-bis [2-(4-aminophenyl)isopropyl] benzene, 1,4-bis[2-(3-aminophenyl)isopropyl]benzene, 1,4-bis[2-(4-aminophenyl)isopropyl]benzene, 4,4"-diamino-p-terphenyl and 4,4"-diamino-m-terphenyl. These may be used singly, or two or more may be used in combination.

Of these, from the standpoint of increasing the function of the resulting layer as a release layer, an aromatic diamine without substituents such as methyl on the aromatic ring or on the aromatic ring and heterocycles fused therewith is preferred. Specific examples include p-phenylenediamine, m-phenylenediamine, 2-(3-aminophenyl)-5-aminobenzimidazole, 2-(4-aminophenyl)-5-aminobenzoxazole and 4,4"-diamino-p-terphenyl.

From the standpoint of enhancing the flexibility, heat resistance and other properties of the resulting release layer, the diamine component of the invention may include diamines other than aromatic diamines. Preferred examples include diamines of formula (S).

[Chem. 7]

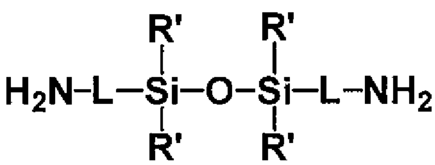

(S)

In formula (S), each L is independently an alkanediyl group of 1 to 20 carbon atoms, an alkenediyl group of 2 to 20 carbon atoms or an alkynediyl group of 2 to 20 carbon atoms, and each R' is independently an alkyl group of 1 to 20 carbon atoms, an alkenyl group of 2 to 20 carbon atoms or an alkynyl group of 2 to 20 carbon atoms.

The number of carbon atoms on such alkanediyl groups, alkenediyl groups and alkynediyl groups is preferably 10 or less, and more preferably 5 or less.

Of these, taking into account the balance between the solubility of the resulting polyamic acid in organic solvents and the heat resistance of the resulting film, an alkanediyl group is preferred, a $-(CH_2)_n-$ group (n = 1 to 10) is more preferred, and a $-(CH_2)_n-$ group (n = 1 to 5) is even more preferred. From the standpoint of availability, a trimethylene group is even more preferred.

The alkyl groups of 1 to 20 carbon atoms, alkenyl groups of 2 to 20 carbon atoms and alkynyl groups of 2 to 20 carbon atoms are exemplified in the same way as above.

Of these, taking into account the balance between the solubility of the resulting polyamic acid in organic solvents and the heat resistance of the resulting film, the R' groups are preferably alkyl groups of 1 to 20 carbon atoms, and more preferably methyl and ethyl groups.

Taking into account the availability of the diamine and the function of the resulting film as a release layer, the diamine of formula (S) is most suitably 1,3-bis(3-aminopropyl)tetramethyldisiloxane. The diamine of formula (S) may be

acquired as a commercial product, or may be synthesized by a known method (such as the method described in WO 2010/108785).

In addition, other diamines may be used together with the above aromatic diamines, provided that doing so does not impart adverse effects on the resulting release layer.

Specific examples of such other diamines include alicyclic diamines such as 1,4-diaminocyclohexane, 1,4-cyclohexanebis(methylamine), 4,4'-diaminodicyclohexylmethane, bis(4-amino-3-methylcyclohexyl)methane, 3(4),8(9)-bis(aminomethyl)tricyclo[5.2.1.$0^{2,6}$]decane, 2,5(6)-bis(aminomethyl)bicyclo[2.2.1]heptane, 1,3-diaminoadamantane, 3,3'-diamino-1,1'-biadamantyl and 1,6-diaminodiamantane(1,6-aminopentacyclo[7.3.1.$1^{4,12}$.$0^{2,7}$.$0^{6,11}$]tetradecane); and aliphatic diamines such as tetramethylenediamine and hexamethylenediamine.

In this invention, the amount of aromatic diamine in the overall diamine component is preferably at least 70 mol%, more preferably at least 80 mol%, even more preferably at least 90 mol%, and still more preferably at least 95 mol%. In particular, when a diamine of formula (S) is used together with an aromatic diamine, the aromatic diamine accounts for preferably at least 80 mol%, more preferably at least 90 mol%, even more preferably at least 95 mol%, and still more preferably at least 97 mol%, of the combined amount of the aromatic diamine and the diamine of formula (S). By using the aromatic diamine in such an amount, a film which firmly adheres to the base and has a suitable adhesion to and a suitable releasability from the plastic substrate can be reproducibly obtained.

The charging ratio between the diamine component and the tetracarboxylic dianhydride component is suitably determined while taking into account such factors as the target molecular weight and molecular weight distribution, the type of diamine and the type of tetracarboxylic dianhydride, and therefore cannot be strictly specified. However, in order for both ends on the molecular chain to be derived from diamine, it is preferable to make the number of moles of the diamine component somewhat higher than the number of moles of the tetracarboxylic dianhydride component. The specific molar ratio is preferably from 1.00 to 2.5 moles, more preferably from 1.01 to 1.5 moles, and even more preferably from 1.02 to 1.3 moles, of the diamine component per mole of the tetracarboxylic dianhydride component.

By additionally reacting an aromatic dicarboxylic acid with the polyamic acid having amino groups at both ends of the molecular chain and obtained by reaction of the above-described tetracarboxylic dianhydride component with the above-described diamine component, the amine-capped polyamic acid included in the release layer-forming composition of the invention can be obtained.

The aromatic dicarboxylic acid or aromatic dicarboxylic acid anhydride used to cap both ends of the molecular chain in the polyamic acid obtained by reacting the tetracarboxylic dianhydride component with the diamine component is preferably one having an aromatic ring of from 6 to 30 carbon atoms, more preferably one having an aromatic ring of from 6 to 15 carbon atoms, and even more preferably one having an aromatic ring of from 6 to 10 carbon atoms.

Specific examples of the aromatic dicarboxylic acid or aromatic dicarboxylic acid anhydride include aromatic dicarboxylic acids such as o-phthalic acid, isophthalic acid, terephthalic acid, 5-methylisophthalic acid, 5-tert-butylisophthalic acid, 5-aminoisophthalic acid, 5-hydroxyisophthalic acid, 2,5-dimethylterephthalic acid, tetramethylterephthalic acid, 1,4-naphthalenedicarboxylic acid, 2,5-naphthalenedicarboxylic acid, 2,6-naphthalenedicarboxylic acid, 2,7-naphthalenedicarboxylic acid, 1,4-anthracenedicarboxylic acid, 1,4-anthraquinonedicarboxylic acid, 2,5-biphenyldicarboxylic acid, 4,4'-biphenyldicarboxylic acid, 1,5-biphenylenedicarboxylic acid, 4,4"-terphenyldicarboxylic acid, 4,4'-diphenylmethanedicarboxylic acid, 4,4'-diphenylethanedicarboxylic acid, 4,4'-diphenylpropanedicarboxylic acid, 4,4'-diphenylhexafluoropropanedicarboxylic acid, 4,4'-diphenyl ether dicarboxylic acid, 4,4'-bibenzyldicarboxylic acid, 4,4'-stilbenedicarboxylic acid, 4,4'-tolanedicarboxylic acid, 4,4'-carbonyldibenzoic acid, 4,4'-sulfonyldibenzoic acid, 4,4'-dithiodibenzoic acid, p-phenylenediacetic acid, 3,3'-p-phenylenedipropionic acid, 4-carboxycinnamic acid, p-phenylenediacrylic acid, 3,3' - [4,4' -(methylenedi-p-phenylene)] dipropionic acid, 4,4'-[4,4'-(oxydi-p-phenylene)]dipropionic acid, 4,4'-[4,4'-(oxydi-p-phenylene)]dibutyric acid, (isopropylidenedi-p-phenylenedioxy)dibutyric acid and bis(p-carboxyphenyl)dimethylsilane; and aromatic dicarboxylic acid anhydrides such as phthalic anhydride, 2,3-naphthalenedicarboxylic anhydride and 1,8-naphthalenedicarboxylic anhydride. Of these, taking into account such considerations as safety, handleability and reactivity, phthalic anhydride is especially suitable in this invention.

From the standpoint of reliably capping both ends of the molecular chain on the polyamic acid obtained by reacting the tetracarboxylic dianhydride component with the diamine component, the amount of aromatic dicarboxylic acid or aromatic dicarboxylic acid anhydride charged per mole of the polyamic acid is preferably at least 2 moles, more preferably from 2 to 4 moles, and even more preferably from 2 to 3 moles. As for the amount of aromatic dicarboxylic acid or aromatic dicarboxylic acid anhydride added during actual synthesis, it is generally desirable for this to be set to preferably at least 0.1 mole, more preferably from 0.2 to 4 moles, and even more preferably from 0.2 to 3 moles, per mole of the diamine component used in synthesis of the polyamic acid.

The organic solvent used in polyamic acid synthesis and in capping both ends of the molecular chain on the synthesized polyamic acid is not particularly limited, provided that it does not adversely affect the reactions. Specific examples include m-cresol, 2-pyrrolidone, N-methyl-2-pyrrolidone, N-ethyl-2-pyrrolidone, N-vinyl-2-pyrrolidone, N,N-dimethylacetamide, N,N-dimethylformamide, 3-methoxy-N,N-dimethylpropylamide, 3 -ethoxy-N,N-dimethylpropylamide, 3 -propoxy-N,N-dimethylpropylamide, 3-isopropoxy-N,N-dimethylpropylamide, 3-butoxy-N,N-dimethylpropylamide, 3-sec-butoxy-N,N-dimethylpropylamide, 3-tert-butoxy-N,N-dimethylpropylamide and γ-butyrolactone. The organic solvent may be used singly or two or more may be used in combination.

The reaction temperature when synthesizing the polyamic acid should be suitably set in the range of from the melting point to the boiling point of the solvent used, and typically from about 0°C to about 100°C. From the standpoint of preventing imidization of the resulting polyamic acid in solution and maintaining a high content of polyamic acid units, the reaction temperature may be set to preferably from about 0°C to about 70°C, more preferably from about 0°C to about 60°C, and even more preferably from about 0°C to about 50°C. The reaction time depends on the reaction temperature and the reactivities of the starting materials and therefore cannot be strictly specified, but is generally from about 1 hour to about 100 hours.

The reaction temperature when capping both ends of the molecular chain in the polyamic acid, as during synthesis of the polyamic acid, may be suitably set in the range of from the melting point to the boiling point of the solvent used, and typically from about 0°C to about 100°C. From the standpoint of reliably capping both ends of the molecular chain in the synthesized polyamic acid, the reaction temperature may be set to preferably from about 0°C to about 70°C, more preferably from about 0°C to about 60°C, and even more preferably from about 0°C to about 50°C. The reaction time depends on the reaction temperature and the reactivities of the starting materials and therefore cannot be strictly specified, but is generally from about 1 hour to about 100 hours.

The weight-average molecular weight of the carboxylic acid-capped polyamic acid thus obtained is generally from about 5,000 to about 500,000. However, from the standpoint of improving the function of the resulting film as a release layer, the weight-average molecular weight is preferably from about 6,000 to about 200,000, and more preferably from about 7,000 to about 150,000. In this invention, the weight-average molecular weight is a polystyrene-equivalent value obtained by gel permeation chromatographic (GPC) measurement.

Specific examples of polyamic acids that can be suitably used in the invention include, but are not limited to, those of the following formula.

[Chem. 8]

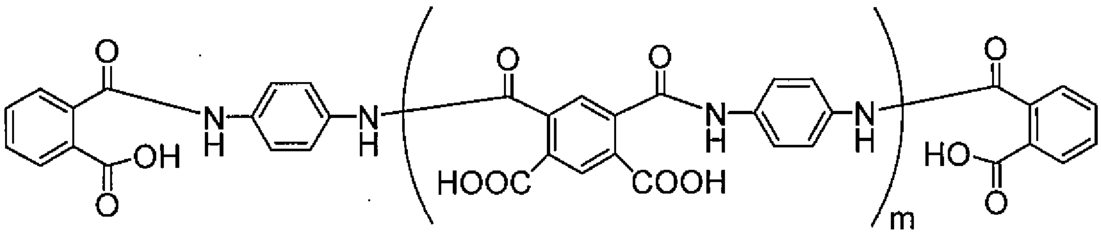

In this formula, m is defined in the same way as above.

The release layer-forming composition of the invention includes an organic solvent. Organic solvents similar to the above-mentioned examples of reaction solvents used in the reaction may be used as this organic solvent. However, it is preferable to include at least one solvent selected from among amides of formula (S1) below, amides of formula (S2) below and amides of formula (S3) below because such solvents fully dissolve the carboxylic acid-capped polyamic acid of the invention, enabling a highly uniform composition to be readily prepared.

[Chem. 9]

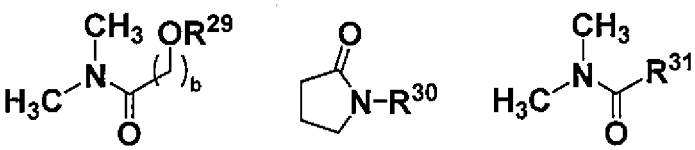

(S1) (S2) (S3)

In these formulas, $R^{29}$ and $R^{30}$ are each independently an alkyl group of 1 to 10 carbon atoms, and $R^{31}$ is a hydrogen atom or an alkyl group of 1 to 10 carbon atoms. The subscript b is a natural number, preferably a natural number from 1 to 5, and more preferably a natural number from 1 to 3.

The alkyl group of 1 to 10 carbon atoms is exemplified in the same way as mentioned above.

Specific examples of organic solvents of above formulas (S1) to (S3) include 3-methoxy-N,N-dimethylpropionamide, N,N-dimethylformamide, N,N-dimethylacetamide, N,N-dimethylpropionamide, N,N-dimethylbutanamide, N-methyl-2-pyrrolidone and N-ethyl-2-pyrrolidone. Of these, N-methyl-2-pyrrolidone is preferred. These organic solvents may be used singly or two or more may be used in combination.

Even a solvent that does not by itself dissolve the polyamic acid may be used in preparation of the composition so long as such use is in a range where the polyamic acid does not precipitate. In particular, solvents having a low surface tension may be suitably intermixed. Examples of such solvents include ethyl cellosolve, butyl cellosolve, ethyl carbitol, butyl carbitol, ethyl carbitol acetate, ethylene glycol, 1-methoxy-2-propanol, 1-ethoxy-2-propanol, 1-butoxy-2-propanol, 1-phenoxy-2-propanol, propylene glycol monoacetate, propylene glycol diacetate, propylene glycol 1 -monoethyl ether 2-acetate, propylene glycol 1-monoethyl ether 2-acetate, dipropylene glycol, 2-(2-ethoxypropoxy)propanol, methyl lactate, ethyl lactate, n-propyl lactate, n-butyl lactate and isoamyl lactate. It is known that, by doing so, the uniformity of the applied film when the composition is applied onto a substrate improves. Hence, such solvents can be suitably used in this invention as well.

The release layer-forming composition of the invention can be prepared by an ordinary method. A good example of a method of preparation is one in which a reaction mixture containing the target polyamic acid obtained by the above-described method is filtered, and the concentration of the resulting filtrate is set to a predetermined concentration using the above-described organic solvent. By using such a method, not only is it possible to reduce the incorporation of impurities that may worsen the adhesion, releasability and other properties of the release layer produced from the resulting composition, a release layer-forming composition can be efficiently obtained.

The concentration of the carboxylic acid-capped polyamic acid in the release layer-forming composition of the invention, which is suitably set while taking into account such factors as the thickness of the release layer to be produced and the viscosity of the composition, is generally from about 1 wt% to about 30 wt%, and preferably from about 1 wt% to about 20 wt%. At such a concentration, a release layer having a thickness of from about 0.05 μm to about 5 μm can be reproducibly obtained. The carboxylic acid-capped polyamic acid concentration can be adjusted by, for example, adjusting the amounts in which the diamine component, the tetracarboxylic dianhydride component and the aromatic dicarboxylic acid that serve as starting materials of the polyamic acid are used, or by adjusting the amount of isolated carboxylic acid-capped polyamic acid when it is dissolved in a solvent.

The viscosity of the release layer-forming composition of the invention is suitably set while taking into account, for example, the thickness of the release layer that is to be produced. However, particularly in cases where the aim is to reproducibly obtain a film having a thickness of from about 0.05 μm to about 5 μm, the viscosity at 25°C is generally from about 10 to about 10,000 mPa·s, and preferably from about 20 to about 5,000 mPa·s.

Here, the viscosity can be measured at a composition temperature of 25°C using a commercial viscometer for measuring the viscosity of liquids, such as by the procedure described in JIS K7117-2. The viscometer used is preferably a cone/plate type rotational viscometer. Measurement can be carried out using preferably a standard 1°34' × R24 cone rotor in this type of viscometer at a composition temperature of 25°C. An example of such a rotational viscometer is the TVE-25L from Toki Sangyo Co., Ltd.

Aside from the carboxylic acid-capped polyamic acid and the organic solvent, the release layer-forming composition of the invention may also include a crosslinking agent or the like in order to increase, for example, the film strength.

By applying the above-described release layer-forming composition of the invention onto a base and heating the resulting applied layer to effect thermal imidization of the carboxylic acid-capped polyamic acid, a release layer made of a polyimide film which firmly adheres to a base and has a suitable adhesion to and a suitable releasability from a plastic substrate can be obtained.

When forming such a release layer according to the invention, the release layer may be formed over part of the surface of a base or may be formed over the entire surface. Embodiments in which the release layer is formed over part of the surface of the base include embodiments in which the release layer is formed over only a given range of the surface of the base, and embodiments in which the release layer is formed in a pattern, such as a dot pattern or a line-and-space pattern, over the entire surface of the base. In this invention, "base" refers to a body which is coated on the surface with the release layer-forming composition of the invention, and which can be used in the fabrication of flexible electronic devices and the like.

Examples of the base (base material) include glass, plastic (polycarbonate, polymethacrylate, polystyrene, polyester, polyolefin, epoxy, melamine, triacetyl cellulose, ABS, AS, norbornene resins, etc.), metals (silicon wafers, etc.), wood, paper and slate. In this invention, a glass base may be suitably used, particularly because the release layer fully adheres thereto. The surface of the base may be made of a single material or may be made of two or more materials. Embodiments in which the surface of the base is made of two or more materials include embodiments in which some region of the base surface is made of a single material and the remaining regions are made of another material, and embodiments in which one material is present in a pattern, such as a dot pattern or line-and-space pattern, within another material over the entire surface of the base.

Examples of methods for applying the release layer-forming composition of the invention onto the base include,

without particular limitation, cast coating, spin coating, blade coating, dip coating, roll coating, bar coating, die coating, inkjet coating, and printing (letterpress printing, intaglio printing, lithography, screen printing, etc.).

The heating temperature for imidization is suitably set within a range of generally from 50 to 550°C, but is preferably greater than 150°C and up to 510°C. By setting the heating temperature in this range, it is possible to have the imidization reaction fully proceed while preventing embrittlement of the resulting film. The heating time differs with the heating temperature and thus cannot be strictly specified, but is generally from 5 minutes to 5 hours. The imidization yield should be in the range of from 50 to 100%.

A preferred example of the mode of heating in the invention is a method which carries out heating at from 50 to 150°C for a period of from 5 minutes to 2 hours, then raises the heating temperature in a stepwise manner from this level and finishes by heating at a temperature greater than 150°C and up to 510°C for a period of from 30 minutes to 4 hours. It is especially preferable to carry out heating at from 50 to 150°C for a period of from 5 minutes to 2 hours, followed by heating at a temperature greater than 150°C and up to 350°C for a period of from 5 minutes to 2 hours, and last of all by heating at a temperature greater than 350°C and up to 450°C for a period of from 30 minutes to 4 hours.

The apparatuses used for heating are exemplified by a hot plate and an oven. The heating atmosphere may be air or an inert gas, and may be under normal pressure or under reduced pressure.

The thickness of the release layer is generally from about 0.01 μm to about 50 μm, although from the standpoint of productivity, the thickness is preferably from about 0.05 μm to about 20 μm. The desired thickness is achieved by adjusting the thickness of the applied film prior to heating.

The release layer described above firmly adheres to the base, particularly a glass base, and has a suitable adhesion to and a suitable releasability from a plastic substrate. Moreover, the performance is stable, with no change in these properties arising before and after heat treatment, particularly in the TFT process. As a result, in a flexible electronic device production process, the release layer of the invention can be suitably used for releasing the plastic substrate of the device, together with a circuit or the like formed on the plastic substrate, from the base without imparting damage to the plastic substrate.

An example of a method for manufacturing flexible electronic devices using the release layer of the invention is described below.

Using the release layer-forming composition of the invention, a release layer is formed on a glass base by the above-described method. A resin solution for forming a plastic substrate is applied onto this release layer and the applied film is heated, thereby forming a plastic substrate anchored to the glass base through the release layer of the invention. At this time, the substrate is formed over a large surface area relative to the surface area of the release layer, such as to cover all of the release layer. The plastic substrate is exemplified by a plastic substrate made of polyimide, which is typical of the plastic substrates in flexible electronic devices. The resin solution for forming such a plastic substrate may be, for example, a polyimide solution or a polyamic acid solution. Formation of the plastic substrate may be carried out in the usual manner.

Next, the desired circuit is formed on the plastic substrate anchored to the base through the release layer of the invention. The plastic substrate is subsequently cut along, for example, the release layer, and the plastic substrate, together with the circuit thereon, is released from the release layer, thereby separating the plastic substrate and the base. At this time, part of the base may be cut together with the release layer.

JP-A 2013-147599 describes the application of the laser lift off (LLO) technique, which has hitherto been used in the fabrication of high-brightness LEDs and three-dimensional semiconductor packages, to the manufacture of flexible displays. The LLO process is characterized by irradiating the glass base side with light having a specific wavelength, such as light having a wavelength of 308 nm, from the surface opposite to that on which circuits or the like have been formed. The irradiated light passes through the glass base and only the polymer (polyimide) in the vicinity of the glass base absorbs this light and vaporizes (sublimates). As a result, it is possible to selectively release the plastic substrate from the glass base without affecting the circuits or the like provided on the plastic substrate that determine the performance of the display.

Because the release layer-forming composition of the invention has the characteristic of fully absorbing light of a specific wavelength (e.g., 308 nm) at which application of the LLO process is possible, the release layer can be used as a sacrificial layer in the LLO process. When a desired circuit is formed on a plastic substrate anchored to a glass base through a release layer formed using the composition of the invention, following which the LLO process is carried out and 308-nm light is irradiated, the release layer alone absorbs this light and vaporizes (sublimates). As a result, the release layer is sacrificed (i.e., it acts as a sacrificial layer), enabling the plastic substrate to be selectively released from the glass base.

## EXAMPLES

The invention is described in greater detail below by way of Examples, although the invention is not limited to these Examples.

[1] Abbreviations of Compounds

| | |
|---|---|
| p-PDA: | p-phenylenediamine |
| DATP: | 4,4"-diamino-p-terphenyl |
| BPDA: | 3,3',4,4'-biphenyltetracarboxylic dianhydride |
| PMDA: | pyromellitic dianhydride |
| H-PAM: | 1,3-bis(3-aminopropyl)tetramethyldisiloxane |
| NMP: | N-methyl-2-pyrrolidone |
| BCS: | butyl cellosolve |

[2] Method of Measuring Weight-Average Molecular Weight and Molecular Weight Distribution

Measurement of the weight-average molecular weight (abbreviated below as "Mw") and molecular weight distribution of the polymer was carried out using a GPC system from JASCO Corporation (column, Shodex KD801 and KD805; eluant, dimethylformamide/LiBr-$H_2O$ (29.6 mM)/$H_3PO_4$ (29.6 mM)/THF (0.1 wt%); flow rate, 1.0 mL/min; column temperature, 40°C; Mw, standard polystyrene-equivalent value).

[3] Synthesis of Polymer

Polyamic acid was synthesized by the following method.

A plastic substrate-forming composition or a release layer-forming composition was prepared by diluting the resulting polymer-containing reaction mixture as subsequently described without isolating the polymer from the reaction mixture.

<Synthesis Example S1: Synthesis of Polyamic Acid (S1)>

p-PDA (20.26 g, 187 mmol) and DATP (12.21 g, 47 mmol) were dissolved in 617 g of NMP. The resulting solution was cooled to 15°C and 50.11 g (230 mmol) of PMDA was added thereto, following which the temperature was raised to 50°C and the reaction was carried out for 48 hours in a nitrogen atmosphere. The resulting polymer had a Mw of 82,100 and a molecular weight distribution of 2.7.

<Synthesis Example S2: Synthesis of Polyamic Acid (S2)>

p-PDA (3.218 g, 30 mmol) was dissolved in 88.2 g of NMP. BPDA (8.581 g, 29 mmol) was added to the resulting solution and the reaction was carried out at 23°C for 24 hours in a nitrogen atmosphere. The resulting polymer had a Mw of 107,300 and a molecular weight distribution of 4.6.

<Synthesis Example L1: Synthesis of Polyamic Acid (L1)>

p-PDA (0.83 g, 7.7 mmol) was dissolved in 17 g of NMP. BPDA (2.17 g, 7.4 mmol) was added to the resulting solution and the reaction was carried out at 23°C for 24 hours in a nitrogen atmosphere. Next, 0.09 g (0.6 mmol) of phthalic anhydride was added and the reaction was additionally carried out for 24 hours. The resulting polymer had a Mw of 20,200 and a molecular weight distribution of 2.0.

<Synthesis Example L2: Synthesis of Polyamic Acid (L2)>

p-PDA (0.83 g, 7.7 mmol) was dissolved in 17 g of NMP. BPDA (2.16 g, 7.4 mmol) was added to the resulting solution and the reaction was carried out at 23°C for 24 hours in a nitrogen atmosphere. Next, 0.11 g (0.8 mmol) of phthalic anhydride was added and the reaction was additionally carried out for 24 hours. The resulting polymer had a Mw of 16,100 and a molecular weight distribution of 2.0.

<Synthesis Example L3: Synthesis of Polyamic Acid (L3)>

p-PDA (0.85 g, 7.9 mmol) was dissolved in 17 g of NMP. BPDA (2.15 g, 7.3 mmol) was added to the resulting solution and the reaction was carried out at 23°C for 24 hours in a nitrogen atmosphere. Next, 0.16 g (1.1 mmol) of phthalic anhydride was added and the reaction was additionally carried out for 24 hours. The resulting polymer had a

Mw of 13,300 and a molecular weight distribution of 1.8.

<Synthesis Example L4: Synthesis of Polyamic Acid (L4)>

p-PDA (0.87 g, 8.0 mmol) was dissolved in 17 g of NMP. BPDA (2.13 g, 7.2 mmol) was added to the resulting solution and the reaction was carried out at 23°C for 24 hours in a nitrogen atmosphere. Next, 0.24 g (1.6 mmol) of phthalic anhydride was added and the reaction was additionally carried out for 24 hours. The resulting polymer had a Mw of 9,700 and a molecular weight distribution of 1.6.

<Synthesis Example L5: Synthesis of Polyamic Acid (L5)>

p-PDA (0.82 g, 7.6 mmol) was dissolved in 17.6 g of NMP. PMDA (1.58 g, 7.3 mmol) was added to the resulting solution and the reaction was carried out at 23°C for 24 hours in a nitrogen atmosphere. Next, 0.09 g (0.6 mmol) of phthalic anhydride was added and the reaction was additionally carried out for 24 hours. The resulting polymer had a Mw of 23,800 and a molecular weight distribution of 2.2.

<Synthesis Example L6: Synthesis of Polyamic Acid (L6)>

p-PDA (0.79 g, 7.3 mmol) and H-PAM (0.02 g, 0.1 mmol) were dissolved in 17.6 g of NMP. PMDA (1.59 g, 7.3 mmol) was added to the resulting solution and the reaction was carried out at 23°C for 24 hours in a nitrogen atmosphere. Next, 0.02 g (0.1 mmol) of phthalic anhydride was added and the reaction was additionally carried out for 24 hours. The resulting polymer had a Mw of 31,500 and a molecular weight distribution of 2.4.

<Synthesis Example L7: Synthesis of Polyamic Acid (L7)>

p-PDA (0.81 g, 7.4 mmol) and H-PAM (0.02 g, 0.1 mmol) were dissolved in 17.6 g of NMP. PMDA (1.58 g, 7.2 mmol) was added to the resulting solution and the reaction was carried out at 23°C for 24 hours in a nitrogen atmosphere. Next, 0.09 g (0.6 mmol) of phthalic anhydride was added and the reaction was additionally carried out for 24 hours. The resulting polymer had a Mw of 24,100 and a molecular weight distribution of 2.3.

<Comparative Synthesis Example 1: Synthesis of Polyamic Acid (B1)>

p-PDA (20.8 g, 192 mmol) was dissolved in 425 g of NMP. BPDA (54.2 g, 184 mmol) was added to the resulting solution and the reaction was carried out at 23°C for 24 hours in a nitrogen atmosphere. The resulting polymer had a Mw of 69,200 and a molecular weight distribution of 2.2.

[4] Preparation of Plastic Substrate-Forming Composition

[Preparation Example 1]

The reaction mixtures obtained in Synthesis Examples S1 and S2 were respectively used directly as Plastic Substrate-Forming Compositions W and X.

[5] Preparation of Release Layer-Forming Compositions

[Working Example 1-1]

A release layer-forming composition was obtained by adding BCS and NMP to the reaction mixture obtained in Synthesis Example L1 and diluting to a polymer concentration of 5 wt% and a BCS concentration of 20 wt%.

[Working Examples 1-2 to 1-7]

Aside from using the reaction mixtures obtained in, respectively, Synthesis Examples L2 to L7 instead of the reaction mixture obtained in Synthesis Example L1, release layer-forming compositions were obtained in the same way as in Working Example 1-1.

[Comparative Example 1]

Aside from using the reaction mixtures obtained in Comparative Synthesis Example 1 instead of the reaction mixture obtained in Synthesis Example L1, a release layer-forming composition was obtained in the same way as in Working Example 1-1.

[6] Formation of Release Layer and Plastic Substrate

[Working Example 2-1]

Using a spin coater (spin-coating conditions: 3,000 rpm for about 30 seconds), the release layer-forming composition obtained in Working Example 1-1 was applied onto a 100 mm × 100 mm glass substrate as the glass base (the same applies below).

Next, the resulting applied film was heated at 80°C for 10 minutes on a hot plate, following which, using an oven, heating was carried out at 300°C for 30 minutes, after which the heating temperature was raised to 400°C (at 10°C/min) and heating was further carried out at 400°C for 30 minutes so as to form an approximately 0.1 μm thick release layer on the glass substrate, thereby giving a release layer-bearing glass substrate. During temperature rise, the film-bearing substrate was heated within the oven without being removed from the oven.

Using a bar coater (gap, 250 μm), the plastic substrate-forming composition was applied onto the release layer (plastic thin film) on glass substrate obtained as described above. The resulting applied film was heated at 80°C for 10 minutes on a hot plate, after which, using an oven, heating was carried out at 140°C for 30 minutes, the heating temperature was raised to 210°C (at 10°C/min, the same applies below), heating was carried out at 210°C for 30 minutes, the heating temperature was raised to 300°C, heating was carried out at 300°C for 30 minutes, the heating temperature was raised to 400°C and heating was carried out at 400°C for 60 minutes so as to form an approximately 20 μm thick polyimide substrate on the release layer, thereby giving a plastic substrate and release layer-bearing glass substrate. During temperature rise, the film-bearing substrate was heated within the oven without being removed from the oven.

Here, using Plastic Substrate-Forming Composition W or X obtained above, two types of plastic substrate and release layer-bearing glass substrates having plastic substrates of differing compositions formed on the release layer were produced. When a polyimide substrate was formed using Plastic Substrate-Forming Composition W, the example was denoted as Working Example 2-1a. When a polyimide substrate was formed using Plastic Substrate-Forming Composition X, the example was denoted as Working Example 2-1b (the same applies in the following working examples).

[Working Examples 2-2 to 2-7]

Aside from using the release layer-forming compositions obtained in, respectively, Working Examples 1-2 to 1-7 instead of the release layer-forming composition obtained in Working Example 1-1, release layers and polyimide substrates were formed and release layer-bearing glass substrates and plastic substrate and release layer-bearing glass substrates were obtained in the same way as in Working Example 2-1.

[Comparative Example 2-1]

Aside from using the release layer-forming composition obtained in Comparative Example 1-1 instead of the release layer-forming composition obtained in Working Example 1-1, a release layer and polyimide substrate were formed and a release layer-bearing glass substrate and a plastic substrate and release layer-bearing glass substrate were obtained in the same way as in Working Example 2-1. Here, the plastic substrate was formed using Plastic Substrate-Forming Composition X.

[7] Evaluation of Releasability

The releasability between the release layer and the glass substrate in the release layer-bearing glass substrate obtained in each of Working Examples 2-1 to 2-7 and in Comparative Example 2-1 was determined by the method described below. The following tests were carried out using the same glass substrate.

<Evaluation of Plastic Thin Film Peeability in Cross-Cut Test>

The release layers on the release layer-bearing glass substrates obtained in Working Examples 2-1 to 2-7 and Comparative Example 2-1 were scored at 1 mm intervals, both vertically and horizontally (the same applies below), to form an array of 100 boxes each measuring 1 mm square.

Pressure-sensitive adhesive tape was attached to this 100-box area, following which the tape was peeled off and the degree of peeling was rated according to the following criteria (5B to 0B, B, A, AA). The results are shown in Table 1.

<Rating Criteria>

| | |
|---|---|
| 5B: | 0% peeled (no peeling) |
| 4B: | less than 5% peeled |
| 3B: | 5 to 15% peeled |
| 2B: | at least 15% but less than 35% peeled |
| 1B: | at least 35% but less than 65% peeled |
| 0B: | at least 65% but less than 80% peeled |
| B: | at least 80% but less than 95% peeled |
| A: | at least 95% but less than 100% peeled |
| AA: | 100% peeled (all peeled) |

<Evaluation of Initial Peel Strength of Plastic Substrate>

The plastic substrates on the plastic substrate and release layer-bearing glass substrates obtained in Working Examples 2-1 to 2-7 and in Comparative Example 2-1 were cut into 25 mm wide strips with a cutter. Test specimens were formed by attaching cellophane tape to the end of each cut plastic substrate strip. Using a push-pull tester from Attonic Ltd., these test specimens were subjected to a peel test at a peel angle of 90°, and the peel strength was rated according to the following criteria. The results are shown in Table 1.

<Rating Criteria>

| | |
|---|---|
| 4b: | did not peel |
| 3b: | peel strength was 1.00 N/25 mm or more |
| 2b: | peel strength was at least 0.80 N/25 mm but less than 1.00 N/25 mm |
| 1b: | peel strength was at least 0.60 N/25 mm but less than 0.80 N/25 mm |
| 0b: | peel strength was at least 0.40 N/25 mm but less than 0.60 N/25 mm |
| b: | peel strength was at least 0.30 N/25 mm but less than 0.40 N/25 mm |
| a: | peel strength was at least 0.20 N/25 mm but less than 0.30 N/25 mm |
| aa: | peel strength was less than 0.20 N/25 mm |

<Evaluation of Peel Strength of High Temperature-Treated Plastic Substrate>

The plastic substrates on the plastic substrate and release layer-bearing glass substrates obtained in Working Examples 2-1 to 2-7 and in Comparative Example 2-1 for which the initial peel strength had been evaluated were heated at 400°C for 6 hours in an oven, thereby carrying out high-temperature treatment like that in the TFT process. Next, as in the initial peel strength evaluations, a 90° peel test was carried out on the plastic substrate. The resulting peel strength was rated according to the same criteria as the initial peel strength.

<Evaluation of Amount of Change in Peel Strength>

The amount of change between the peel strength before high-temperature treatment and the peel strength after high-temperature treatment was computed from the following formula. The degree of change in the peel strength was rated according to the criteria shown below. The results are shown in Table 1.

$$\text{Amount of change (\%)} = [\{(\text{peel strength after high-temperature treatment}) - (\text{peel strength before high-temperature treatment})\} / (\text{peel strength before high-temperature treatment})] \times 100$$

○: less than 40% change in peel strength (good release)
Δ: at least 40% but less than 70% change in peel strength
×: at least 70% but less than 100% change in peel strength
××: at least 100% change in peel strength (peel strength worsened)

[Table 1]

| | Type of plastic substrate | Releasability between release layer and glass substrate | Initial peel strength of plastic substrate | Peel strength after high-temperature treatment | Rating of amount of change in peel strength |
|---|---|---|---|---|---|
| Working Example 2-1a | W | 5B | aa | aa | ○ |
| Working Example 2-1b | X | 5B | aa | aa | ○ |
| Working Example 2-2a | W | 5B | aa | aa | ○ |
| Working Example 2-2b | X | 5B | aa | aa | ○ |
| Working Example 2-3 a | W | 5B | aa | aa | ○ |
| Working Example 2-3b | X | 5B | aa | aa | ○ |
| Working Example 2-4a | W | 5B | aa | aa | ○ |
| Working Example 2-4b | X | 5B | aa | aa | ○ |
| Working Example 2-5a | W | 5B | aa | aa | ○ |
| Working Example 2-5b | X | 5B | aa | aa | ○ |
| Working Example 2-6a | W | 5B | aa | aa | ○ |

(continued)

| | Type of plastic substrate | Releasability between release layer and glass substrate | Initial peel strength of plastic substrate | Peel strength after high-temperature treatment | Rating of amount of change in peel strength |
|---|---|---|---|---|---|
| Working Example 2-6b | X | 5B | aa | aa | ○ |
| Working Example 2-7a | W | 5B | aa | aa | ○ |
| Working Example 2-7b | X | 5B | aa | aa | ○ |
| Comparative Example 2-1 | X | 5B | 4b | - | × |

As shown in Table 1, the release layers in the working examples showed no change in peel strength even after high-temperature treatment.

On the other hand, the release layer in Comparative Example 2-1 firmly adhered to the glass substrate and also had an excellent releasability from the plastic substrate, but the peel strength following high-temperature treatment worsened.

**Claims**

1. A release layer-forming composition comprising a polyamic acid, both ends of which are derived from a diamine and capped with an aromatic dicarboxylic acid, and an organic solvent.

2. The release layer-forming composition of claim 1, wherein the aromatic dicarboxylic acid has an aromatic ring of from 6 to 30 carbon atoms.

3. The release layer-forming composition of claim 2, wherein the polyamic acid is represented by formula (1) below.

[Chem. 1]

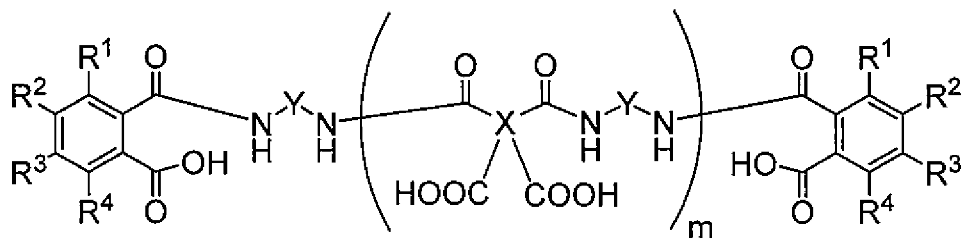

(1)

(wherein X is a tetravalent aromatic group, Y is a divalent aromatic group, $R^1$ to $R^4$ are each independently a hydrogen atom, an alkyl group of 1 to 10 carbon atoms or an aryl group of 6 to 20 carbon atoms, and m is a natural number).

4. The release layer-forming composition of claim 3, wherein $R^1$ to $R^4$ are hydrogen atoms.

5. The release layer-forming composition of claim 3 or 4, wherein Y is a divalent aromatic group that includes from 1 to 5 benzene rings.

6. The release layer-forming composition of claim 5, wherein Y is at least one group selected from those of formulas (2) to (4) below.

[Chem. 2]

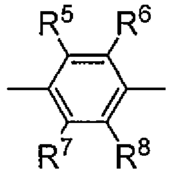

(2)

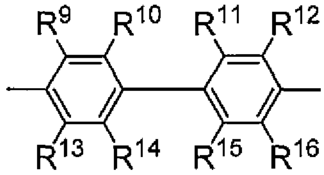

(3)

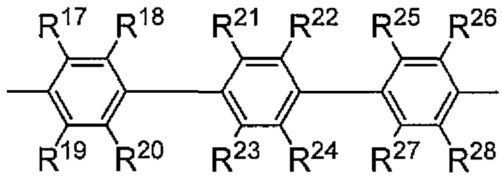

(4)

(wherein $R^5$ to $R^{28}$ are each independently a hydrogen atom, a halogen atom, a hydroxyl group, a nitro group, a cyano group, or an alkyl group of 1 to 20 carbon atoms, alkenyl group of 2 to 20 carbon atoms, alkynyl group of 2 to 20 carbon atoms, aryl group of 6 to 20 carbon atoms or heteroaryl group of 2 to 20 carbon atoms which may be substituted with a halogen atom).

7. The release layer-forming composition of claim 6, wherein $R^5$ to $R^{28}$ are hydrogen atoms.

8. The release layer-forming composition of any one of claims 3 to 7, wherein X is a tetravalent aromatic group that includes from 1 to 5 benzene rings.

9. The release layer-forming composition of any one of claims 3 to 8, wherein X is a phenyl group or a biphenyl group.

10. The release layer-forming composition of any one of claims 3 to 9, wherein m is a natural number of up to 100.

11. The release layer-forming composition of any one of claims 1 to 10, wherein the organic solvent is at least one selected from the group consisting of amides of formula (SI), amides of formula (S2) and amides of formula (S3).

[Chem. 3]

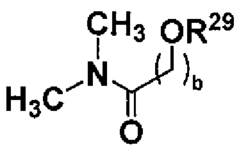

(S1)

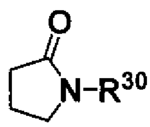

(S2)

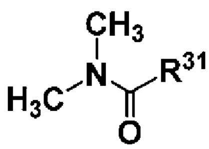

(S3)

(wherein $R^{29}$ and $R^{30}$ are each independently an alkyl group of 1 to 10 carbon atoms, $R^{31}$ is a hydrogen atom or an alkyl group of 1 to 10 carbon atoms, and b is a natural number).

12. A release layer formed with the release layer-forming composition of any one of claims 1 to 11.

13. A method of manufacturing a flexible electronic device having a plastic substrate, which method comprises using the release layer of claim 12.

**14.** The manufacturing method of claim 13, wherein the plastic substrate is a substrate made of polyimide.

**INTERNATIONAL SEARCH REPORT**

International application No. PCT/JP2017/019117

A. CLASSIFICATION OF SUBJECT MATTER
*C08L79/08*(2006.01)i, *C08G73/10*(2006.01)i, *C08K5/3415*(2006.01)i, *C09D7/12*(2006.01)i, *C09D179/08*(2006.01)i

According to International Patent Classification (IPC) or to both national classification and IPC

B. FIELDS SEARCHED

Minimum documentation searched (classification system followed by classification symbols)
C08L79/08, C08G73/10, C08K5/3415, C09D7/12, C09D179/08

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | JP 2012-93746 A (Dainippon Printing Co., Ltd.), 17 May 2012 (17.05.2012), claim 1; paragraphs [0151], [0224], [0236], [0238], [0239] & JP 2016-21068 A | 1-14 |
| X | WO 2008/004496 A1 (Toray Industries, Inc.), 10 January 2008 (10.01.2008), claims 1, 6; paragraphs [0060], [0065], [0067], [0084]; table 1 & US 2009/0252957 A1 claims 1, 6; paragraphs [0066], [0069], [0071], [0086]; table 1 & EP 2039715 A1 & KR 10-2009-0111797 A & CN 101484500 A | 1-14 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 July 2017 (06.07.17) | 18 July 2017 (18.07.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No. PCT/JP2017/019117

C (Continuation). DOCUMENTS CONSIDERED TO BE RELEVANT

| Category* | Citation of document, with indication, where appropriate, of the relevant passages | Relevant to claim No. |
|---|---|---|
| A | JP 10-138318 A (Ube Industries, Ltd.), 26 May 1998 (26.05.1998), paragraphs [0034] to [0036] (Family: none) | 1-14 |
| A | WO 2012/141293 A1 (Toyobo Co., Ltd.), 18 October 2012 (18.10.2012), table 1 & US 2014/0042662 A1 table 1 & CN 103619591 A & KR 10-2014-0027265 A | 1-14 |
| A | JP 2004-352912 A (Teijin Ltd.), 16 December 2004 (16.12.2004), claim 1; paragraph [0099] (Family: none) | 1-14 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP H10125929 A
- JP H10125931 A
- WO 2005050754 A
- JP H10125930 A
- JP 2010111853 A
- JP 2008188792 A
- WO 2010108785 A
- JP 2013147599 A